Europäisches Patentamt

European Patent Office

Office européen des brevets

(19)

(11) Publication number: **0 173 148**
**A2**

# EUROPEAN PATENT APPLICATION

(21) Application number: 85110031.3

(51) Int. Cl.⁴: **H 03 K 19/003**

(22) Date of filing: 09.08.85

(30) Priority: 29.08.84 JP 178257/84

(71) Applicant: FUJITSU LIMITED, 1015, Kamikodanaka Nakahara-ku, Kawasaki-shi Kanagawa 211 (JP)

(72) Inventor: Enomoto, Hiromu, 1-15-1225, Kawaracho Saiwai-ku, Kawasaki-shi Kanagawa 210 (JP)
Inventor: Yasuda, Yasushi, 1405-5-304, Shinkojimachi, Machida-shi Tokyo 194-01 (JP)
Inventor: Kumagai, Masao, 316, Yamabukicho, Shinjuki-ku Tokyo 162 (JP)
Inventor: Tahara, Akinori, 7-15-25, Kotsubo, Zushi-shi Kanagawa 249 (JP)

(43) Date of publication of application: 05.03.86 Bulletin 86/10

(74) Representative: Schmidt-Evers, Jürgen, Dipl.-Ing. et al, Patentanwälte Dipl.-Ing. H. Mitscherlich Dipl.-Ing. K. Gunschmann Dipl.-Ing. Dr.rer.nat. W. Körber Dipl.-Ing. J. Schmidt-Evers Dipl.-Ing. W. Melzer Steinsdorfstrasse 10, D-8000 München 22 (DE)

(84) Designated Contracting States: DE FR GB

(54) A logic circuit.

(57) The present invention relates to a logic circuit which reduces occurrence of breakdown of a pull-down transistor ($T_3$) and a pull-up transistor ($T_4$; $T_8$) in the output stage when a high voltage is applied to the power supply line and ensures high voltage resistance. The logic circuit of the present invention controls the pull-up transistor ($T_4$; $T_8$) provided between a first power supply ($V_{cc}$) and an output terminal (OUT) for ON and OFF with a collector voltage of a phase splitter transistor ($T_2$) and controls the pull-down transistor ($T_3$) provided between the second power supply (GND) and the output terminal (OUT) with an emitter voltage. Breakdown of said pull-down and pull-up transistors ($T_3$; $T_4$; $T_8$) can be reduced and a high voltage resistance is ensured by providing a protection circuit (P) which discharges the base of pull-down transistor ($T_3$) and turns OFF said pull-down transistor ($T_3$) by detecting a voltage difference between the first power supply ($V_{cc}$) and the second power supply (GND) when it exceeds the specified value.

0173148

August 9, 1985

TITLE OF THE INVENTION

A Logic Circuit


FIELD OF THE INVENTION

The present invention relates to a logic circuit and particularly to a logic circuit comprising a protection circuit which prevents breakdown of transistors in the output stage when a high voltage is applied to the power supply.


BACKGROUND OF THE INVENTION

The logic circuits such as Transistor Transistor Logic (TTL), Diode Transistor Logic (DTL), etc. are used in some cases near a device which generates a high voltage. For example, in case such logic circuits are used in the circuits connected to the peripheral devices such as CRT display device of a personal computer, a surge voltage of several hundreds to several tens of hundred voltage is applied to the power supply line of a logic circuit in a moment when the power supply switch of the peripheral circuits is turned ON or OFF and thereby the transistors in the output stage of such logic circuit may be broken.

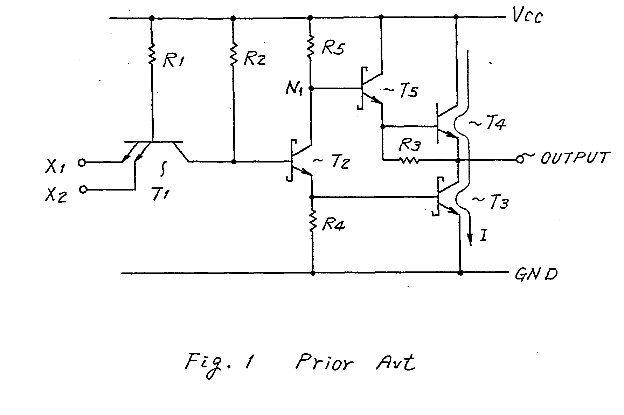

The process until occurrence of breakdown of transistors in the output stage of such logic circuit are explained with reference to a conventional 2-input NAND TTL circuit shown in Fig. 1. A multiemitter npn transistor $T_1$ of the input stage in Fig. 1 comprises a base connected to a power supply line $V_{cc}$ through a resistor $R_1$, a collector connected to the base of a phase splitter transistor $T_2$ and two emitters to which a couple of input signals $X_1$ and $X_2$ are applied. Such phase splitter transistor $T_2$ comprises a collector connected to the power supply line $V_{cc}$ through a resistor $R_5$ and an emitter connected to the base of a pull-down transistor $T_3$ of the output stage. The collector of phase splitter transistor $T_2$ is connected to the base of a transistor $T_5$, which comprises a collector connected to the power supply line $V_{cc}$ and an emitter connected to the base of a pull-up transistor $T_4$ in the output stage. The collector of the pull-up transistor $T_4$ is connected to the power supply line $V_{cc}$. The emitter of the pull-down transistor $T_3$ is connected to a ground line/GND. Both emitter of the pull-up transistor $T_4$ and collector of the pull-down transistor $T_3$ are connected to an output terminal OUTPUT. Such pull-up transistor $T_4$ and transistor $T_5$ form an off-buffer circuit which operates with fast switching speed by improving the rising characteristic when the pull-down transistor $T_3$ is cut-off, namely a potential of output terminal OUTPUT changes to H level from L level with an output impedance kept lower. The base and emitter of the pull-up transistor $T_4$ are connected through a resistor $R_3$ to make OFF the transistor $T_4$ by discharging the base thereof and make fast the falling characteristic of the potential at the output terminal OUTPUT when such transistor $T_4$ is cut-off. The base of pull-down transistor $T_3$ and the ground line GND are connected through a resistor $R_4$ to discharge the base of such transistor $T_3$ and make fast the rising characteristic of potential at the output terminal OUTPUT. A resistor $R_2$ is connected between the power supply line $V_{cc}$ and the base of phase splitter transistor $T_2$. This resistor $R_2$ supplies a base current to the transistor $T_2$ and this reistor $R_2$ is not always required. It should be noted that the transistors $T_2$, $T_3$ and $T_5$ are Schottky barrier diode clamp tansistors for preventing their excessive saturation.

A TTL circuit of Fig. 1 realizes a NAND function which makes L level the potential of the output terminal OUTPUT only when both input signals $X_1$ and $X_2$ become H level. When both input signals $X_1$ and $X_2$ are

H level, a base-to-collector point of the transistor $T_1$ is forward-biased, a current flows from the power supply line $V_{cc}$ through the reistor $R_1$ and the current becomes a base current of the phase splitter transistor $T_2$ with a current flowing through the resistor $R_2$. In this case, the phase splitter transistor $T_2$ in ON, a current is supplied to the collector of transistor $T_2$ through a resistor $R_5$, such current becomes a collector current and the emitter current of such transistor $T_2$ flows into the base of pull-down transistor $T_3$ and the resistor $R_4$. When the pull-down transistor $T_3$ is ON, since a potential of connecting point $N_1$ of the collector of the phase splitter transistor $T_2$ and the resistor $R_5$ is L level, both the transistor $T_5$ and the pull-up transistor $T_4$ are OFF so that a potential of output terminal OUTPUT becomes L level.

Here, when a high voltage is applied to the power supply line $V_{cc}$, a base current and a collector current of the transistor $T_2$ and also a base current and an emitter current of the transistor $T_3$ increase. Therefore the voltages between the collector and emitter of the transistor $T_2$ and between the base and emitter of the transistor $T_3$ increase due to internal resistors of the transistor $T_2$ and transistor $T_3$, so that a poten-

tial of the connecting point $N_1$ of the transistor $T_2$ and the resistor $R_5$ increases. Consequently, both transistors $T_5$ and $T_4$ become ON. Therefore, since both the pull-down transistor $T_3$ and pull-up transistor $T_4$ in the output stage become ON, an excessive current I flows to the ground line GND from the power supply line $V_{cc}$ through the two transistors $T_3$, $T_4$ in the output stage and thereby these transistors $T_3$, $T_4$ are broken.

That is, the base-emitter junction of the transistors is broken by a penetration of aluminium which is formed as an emitter electrode.

Therefore, it is desired that the pull-down transistor and the pull-up transistor in the output stage are protected from breakdown when a high voltage is applied to the power supply line.

SUMMARY OF THE INVENTION

It is an object of the present invention to provide a logic circuit which has a higher voltage resistance in order to protect the pull-down and pull-up transistors in the output stage from breakdown in case a high voltage is applied to the power supply line.

This object can be attained, according to the present invention, by providing a logic circuit comprising; a first power supply, a second power supply, an output terminal, a phase splitter transistor which turns ON and OFF in accordance with an input signal, a pull-down transistor which is turned ON and OFF by the emitter of phase splitter transistor and is provided between said output terminal and the second power supply, a pull-up transistor which is turned ON and OFF by the potential of collector of said phase splitter transistor and is provided between said first powre supply and the output terminal, and a protection circuit means for detecting that a potential difference between said first and second power supplies exceeds a predetermined level and discharging the base of said pull-down transistor so as to turn OFF said pull-down transistor.

Namely, in the present invention, said protection circuit detects the increase of voltage of the power supply line, forces the pull-down transistor to become OFF and thereby prevents breakdown of the pull-down transistor and pull-up transistor by a heavy current. Therefore, according to the present invention, even when a high voltage is applied to the power supply line, both pull-down transistor and pull-up transistor are free from breakdown due to a heavy current by the simultaneous ON state of the pull-up or pull-down transistor.

BRIEF DESCRIPTION OF THE DRAWINGS

Fig. 1 is a circuit diagram illustrating conventional logic circuit.

Fig. 2 is a logic circuit of a first embodiment of the present invention.

Fig. 3 is a logic circuit of a second embodiment of the present invention.

Fig. 4 is a logic circuit of a third embodiment of the present invention.

Fig. 5 is a logic circuit of a fourth embodiment of the present invention.

Fig. 6, Fig. 7 and Fig. 8 are constitution of the input stage which respectively can be adopted to the first, second, third and fourth embodiments of the present invention.

Further features and advantages of the present invention will be apparent from the ensuing description with reference to the accompanying drawings to which, however, the scope of the invention is no way limited.

DETAILED DESCRIPTION OF THE INVENTION

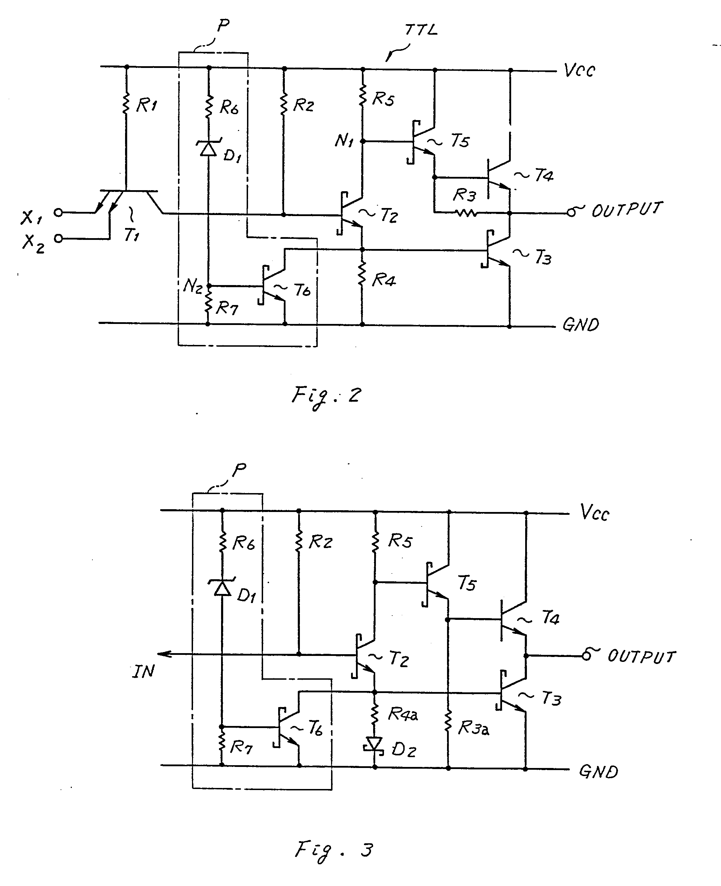

Fig.2 is a logic circuit by an embodiment of the present invention, illustrating an 2-input NAND circuit. In this embodiment, it is a feature of the present invention that a protection circuit P is added in Fig. 2 and other circuit constitution is the same as the prior art.

The protection circuit P is composed of a zener diode $D_1$ and a transistor $T_6$ basically. Namely, the protection circuit P comprises a zener diode $D_1$ where the cathode is connected to the power supply line $V_{cc}$ through a resistor $R_6$ and the anode is connected to the ground GND through a resistor $R_7$ and an npn transistor $T_6$ where the base is connected between the anode of zener diode and reistor $R_7$, the collector is connected to the base of pull-down transistor $T_3$ and the emitter to the ground GND. The transistor $T_6$ is a Schottky barrier diode clamp transistor ·in order to avoid saturation.

If both input signals $X_1$, $X_2$ are H level in Fig. 2, the phase splitter transistor $T_2$ and the pull-down transistor $T_3$ are ON, the transistor $T_5$ and pull-up transistor $T_4$ are OFF, and a potential of ouput terminal OUTPUT becomes L level. During this condition, the high voltage to the power supply makes the output transistors break. That is, when a high voltage is applied to the power supply line $V_{cc}$, a current flowing into the phase splitter transistor $T_2$ and pull-down transistor $T_3$ through the resistor $R_5$ increases and a voltage $V_{CE}(T_2)$ between the collector and emitter of the transistor $T_2$ and a voltage $V_{BE}(T_3)$ between the base and emitter of the transistor $T_3$ increase due to internal resistances of the transistors $T_2$ and $T_3$. Here, a collector resistance of the transistor $T_2$ is largest as the internal resistance and results in large increase of voltage.

Therefore, a potential of the connecting point $N_1$ of the base of transistor $T_5$ and the collector of transistor $T_2$ increases, a potential difference between the output terminal OUTPUT and connecting point $N_1$ exceeds a sum $V_{BES}(T_5) + V_{BES}(T_4)$ of the turn ON voltage $V_{BES}(T_5)$ of transistor $T_5$ and the turn ON voltage $V_{BES}(T_4)$ of pull-up transistor $T_4$, and the transistor $T_5$ and pull-up transistor $T_4$ turn ON from the OFF state. When the pull-up transistor $T_4$ turns ON, both the pull-down transistor $T_3$ and the pull-up transistor $T_4$ are an ON state and therefore a heavy current flows into the transistors $T_3$ and $T_4$ and thereby these

transistors may be broken.

Such breakdown is particularly serious in case the output stage is formed by the pull-up and pull-down transistors. It is because when both transistors become ON, an excessive current flows due to a small impedance.

The breakdown is represented by disconnection of $A\ell$ electrode by melting the electrode material of transistor or breakdown of PN junction by diffusion of electrode material into a semiconductor substrate.

Therefore, the protection circuit P in the embodiment of the present invention operates as follows.

When a high voltage applied to the power supply line $V_{cc}$ is a little lower than a voltage which turns ON the pull-up transistor $T_4$ or is higher than a voltage which turns ON the transistor $T_4$ and does not break the transistors $T_3$ and $T_4$, a voltage applied to the zener diode $D_1$ exceeds the zener voltage as as to turn ON the zener diode. This means the diode $D_1$ detects a high voltage for operating the protection circuit P. Consequently a current flows into a resistor $R_7$ through the zener diode $D_1$. With such current, a potential of the connecting point $N_2$ of the anode of the zener diode $D_1$ and the reistor $R_7$ increases, the

npn transistor $T_6$ of which a base is connected to such connecting point $N_2$ turns ON, the base charges of pull-down transistor $T_3$ are sent to the collector of transistor $T_6$ and thereby the pull-down tansistor $T_3$ is forced to change to OFF from ON.

Here, since a base voltage of pull-down transistor $T_3$ is lowered to $V_{CE}$ $(T_6)$ (a collector-emitter voltage of transistor $T_6$, 0.3V) from $V_{BE}$ $(T_3)$ (almost 0.8V), a potential of connecting point $N_1$ is also lowered. Therefore the transistor $T_5$ and pull-up transistor $T_4$, if these are ON, turn OFF, or if these are OFF, these maintain in the same condition until the voltage of power supply line becomes very high voltage.

Namely, the protection circuit P in this embodiment detects the increase of voltage of the power supply line $V_{cc}$ by the zener diode $D_1$, turns ON the transistor $T_6$, turns OFF the transistor $T_3$ by discharging the base of pull-down transistor $T_3$, also lowers a potential of the connecting point $N_1$ and turns OFF the pull-up transistor $T_4$ and thereby protects the pull-down transistor $T_3$ and pull-up transistor from breakdown for the voltage up to a very high voltage at the power supply line Vcc.

The resistor $R_6$ provided between the cathode of

zener diode $D_1$ and power supply line $V_{cc}$ in the protection circuit P may be provided between the anode of zener diode $D_1$ and the base of transistor $T_6$ or it may be provided in both sides of zener diode $D_1$ by diving it. The resistor $R_6$ is provided for preventing a current breakdown of zener diode $D_1$ when a high voltage is applied to the power supply line $V_{cc}$.

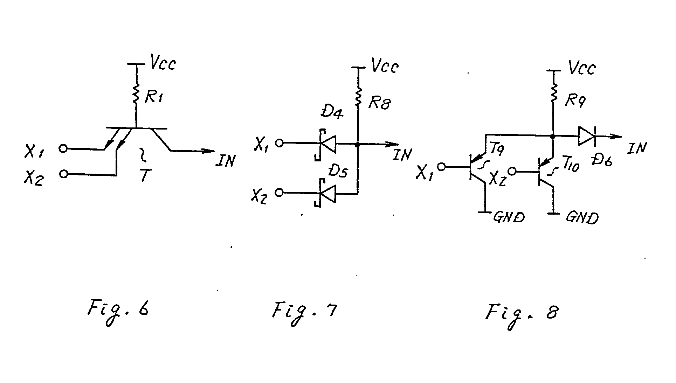

The multi-emitter npn transistor $T_1$ in the intput stage shown in Fig. 2 may also be replaced by the circuit shown in Fig. 7 or Fig. 8. In case where it is replaced with the input circuit of Fig. 7, a Diode Transistor Logic circuit can be constituted.

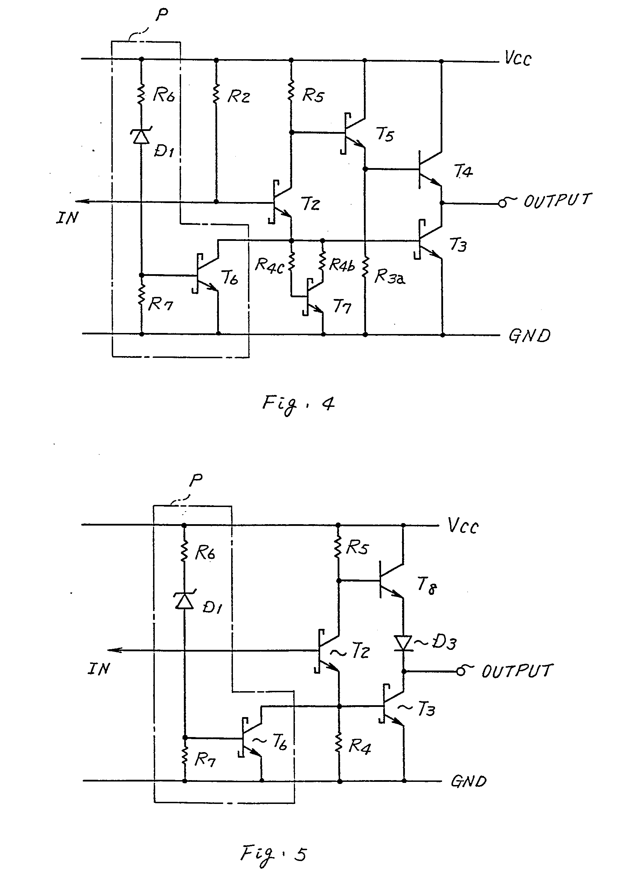

Fig. 3 is a logic circuit of another embodiment of the present invention, Fig. 4 is a logic circuit of another embodiment of the present invention and Fig. 5 is a logic circuit of further embodiment of the present invention.

In the logic circuits of Fig. 3, Fig. 4 and Fig. 5, any input circuit of Fig. 6, Fig. 7 and Fig. 8 can be connected to the base of phase splitter transistor $T_2$, and the same protection circuit P as that in the logic circuit of Fig. 2 is also provided.

The logic circuit of the embodiment shown in Fig. 3 is different from that of Fig. 2 in that a base

discharging resistor $R_{3a}$ is connected between the base of pull-up transistor $T_4$ and the ground GND in place of a base discharging resistor $R_3$ for the pull-up transistor $T_4$ in Fig. 2, and a resistor $R_{4a}$ and diode $D_2$ are connected in series between the base of pull-down transistor $T_3$ and the ground in place of the base discharging resistor $R_4$ for the pull-down transistor $T_3$. Since the base discharging resistor $R_{3a}$ is connected to the ground GND in this embodiment, the output terminal OUTPUT quickly falls to the L level from H level by turning OFF the pull-up transistor $T_4$ from ON and since a diode $D_2$ is provided to the base discharging circuit of the pull-down transistor $T_3$ in the ordinary operation, noise margin becomes large. The protection circuit P in the logic circuit of Fig. 3 protects the pull-down transistor $T_3$ and pull-up transistor $T_4$ from breakdown by current as in the case of the logic circuit shown in Fig. 2.

The logic circuit of an embodiment shown in Fig. 4 is different from that shown in Fig. 3 in such a point that the resistor $R_{4b}$ and resistor $R_{4c}$ and transistor $T_7$ are provided in place of the base discharging resistor $R_{4a}$ and diode $D_2$ shown in Fig. 3. The collector of transistor $T_7$ is connected to the base of

pull-down transistor $T_3$ through the resistor $R_{4b}$, while the base to the base of transistor $T_3$ through the resistor $R_{4c}$ and the emitter to the ground GND. This embodiment operates as in the case of the logic circuit shown in Fig. 3.

The logic circuit of embodiment shown in Fig. 5 is different from that shown in Fig. 2 in such a point that the pull-up transistor $T_8$ and diode $D_3$ forms the off-buffer circuit in place of the pull-up transistor $T_4$ and transistor $T_5$ shown in Fig. 2. The collector of pull-up transistor $T_8$ is connected to the power supply line $V_{cc}$, while the base to the collector of phase splitter transistor $T_2$, and the emitter to the anode of diode $D_3$. The cathode of diode $D_3$ is connected to the collector of pull-down transistor $T_3$. The protection circuit P in Fig. 5 protects the pull-down transistor $T_3$, pull-up transistor $T_8$ and diode $D_3$ from breakdown when a high voltage is applied to the power supply line $V_{cc}$ in the same manner explained above.

Fig.6, Fig.7, and Fig.8 are input circuits to be connected to the base of phase splitter transistor $T_2$ of the logic circuits shown in Fig.3, Fig.4 and Fig.5.

Fig. 6 is an input circuit consisting of a multi-emitter npn transistor $T_1$ of which base is connected to the power supply line $V_{cc}$ through the resistor $R_1$. This circuit outputs the signal IN of the AND logic of the input signals $X_1$ and $X_2$ from the collector for supplying it to the base of the phase splitter transistor $T_2$.

Fig. 7 is an input circuit in which the anodes of Schottky diodes $D_4$ and $D_5$ are commonly connected and the connecting point of $D_4$, $D_5$ is connected to the power supply line $V_{cc}$ through the resistor $R_8$. The input signals $X_1$ and $X_2$ are given to the cathodes of Schottky diodes $D_4$ and $D_5$, thereby the signal IN of AND logic can be obtained at said connecting point. The input circuit shown in Fig. 7 operates faster than the input circuit of Fig. 6 ·

Fig. 8 is an input circuit consisting of the pnp transistors $T_9$ and $T_{10}$ where both emitters are connected each other, such connecting point is connected to the power supply line $V_{cc}$ through the reistor $R_9$ and both collectors are connected to the ground GND and a diode $D_6$ of which anode is connected to said connecting point. The input signals $X_1$ and $X_2$ are given to the bases of pnp transistors $T_9$ and $T_{10}$ so that the signal IN of AND logic obtained at the cathode of diode $D_6$ is supplied to the base of phase splitter transistor $T_2$.

16

In the input circuit of Fig. 8, when the pnp transistors $T_9$ and $T_{10}$ are ON, since a current flowing through the base is smaller than that flowing into the emitter, the input current through $X_1$, $X_2$ can be set smaller than that of the input circuits of Fig. 6 and Fig. 7. Therefore, a number of input terminals to be connected can be increased.

In above explanation, the 2-input NAND circuit is considered for explaining the logic circuit of the present invention, but the present invention is not limited only to such 2-input NAND circuit and other number of input circuits or other kinds of logic function circuits may be used.

C L A I M S

1. A logic circuit characterized in
a first power supply ($V_{cc}$),
a second power supply (GND),
an output terminal (OUT),
a phase splitter transistor ($T_2$) which turns ON and OFF
in accordance with an input signal (IN),
a pull-down transistor ($T_3$) which is controlled ON and
OFF by the emitter of said phase splitter transistor
($T_2$) and is provided between said output terminal (OUT)
and the second power supply (GND),
a pull-up transistor ($T_4$; $T_8$) which is controlled ON and
OFF by the potential of collector of said phase splitter
transistor ($T_2$) and is provided between said first power
supply ($V_{cc}$) and output terminal (OUT), and
a protection circuit means (P) for detecting that a voltage difference between said first power supply ($V_{cc}$)
and second power supply (GND) becomes a predetermined
level, and discharging the base of said pull-down transistor ($T_3$) so as to turn OFF said pull-down transistor
($T_3$).

2. A logic circuit according to claim 1, characterized in
that said protection circuit (P) comprises a zener diode
($D_1$) which turns ON when said voltage difference exceeds
said predetermined level, a resisotr ($R_7$) in which a
current flowing into said zener diode ($D_1$) also flows,
and a discharging transistor ($T_6$) which operates with
a voltage generated when a current flows into said resistor ($R_7$) and discharges the base of said pull-down

transistor ($T_3$).

3. A logic circuit according to claim 2, characterized in that said discharging transistor comprises an npn transistor ($T_6$).

4. A logic circuit according to claim 2 or 3, characterized in that said discharging transistor comprises an npn transistor ($T_6$) having a Schottky barrier diode clamp.

5. A logic circuit according to any one of claims 1 to 4, characterized in that a base discharging means ($R_3$; $R_{3a}$; $R_4$; $R_{4a}$; $D_2$; $R_{4b}$; $R_{4c}$; $T_7$; $D_3$) for said pull-up transistor ($T_4$; $T_8$) and/or for said pull-down transistor ($T_3$) is provided between its base or bases and said second voltage source (GND).

Fig. 1    Prior Art

0173148

Fig. 2

Fig. 3

0173148

Fig. 4

Fig. 5

MUS·08·85

0173148

Fig. 6

Fig. 7

Fig. 8